# EUROPEAN PATENT SPECIFICATION

(11) **EP 2 161 976 B1**
(45) Date of publication and mention of the grant of the patent: **25.09.2013**
(21) Application number: 07721472.4
(22) Date of filing: 15.06.2007
(51) Int. Cl.: H05K 3/34

(54) **METHOD OF MANUFACTURING A SURFACE FINISH STRUCTURE OF A MULTI-LAYER SUBSTRATE**
HERSTELLUNGSVERFAHREN FÜR OBERFLÄCHENBEHANDELTE KONFIGURATION EINER MEHRSCHICHTIGEN LEITERPLATTE
PROCÉDÉ DE FABRICATION DE STRUCTURE DE SURFACE D'UN SUBSTRAT MULTICOUCHE

(43) Date of publication of application: 10.03.2010
(73) Proprietor: Princo Corp., Taiwan (CN)
(72) Inventor: YANG, Chih-kuang, Taiwan (CN); HSING, Chieh-Lin, Taiwan (CN)
(74) Representative: Isarpatent
(86) International application number: PCT/CN2007/001899
(87) International publication number: WO 2008/151472

(56) References cited:
- CN-A- 1 476 289
- CN-A- 1 747 155
- JP-A- 07 193 346
- TW-B- 245 597
- US-A- 2 984 595
- US-A- 5 446 247
- US-A1- 2003 025 202
- US-A1- 2004 099 961
- US-A1- 2005 104 210
- US-A1- 2006 049 516
- US-A1- 2006 055 021
- US-A1- 2006 151 877
- US-A1- 2007 114 674
- US-B2- 7 098 407

## Description

### BACKGROUND OF THE INVENTION

### 1. Field of the Invention

The present invention generally relates to a surface finish structure of multi-layer substrate and manufacturing method thereof, and more particularly, to a surface finish structure of a flexible multi-layer substrate and manufacturing method thereof.

### 2. Description of Prior Art

According to prior arts, a surface finish structure of multi-layer substrate can be categorized into two methods, i.e. Pad Definition and Solder Mask Definition.

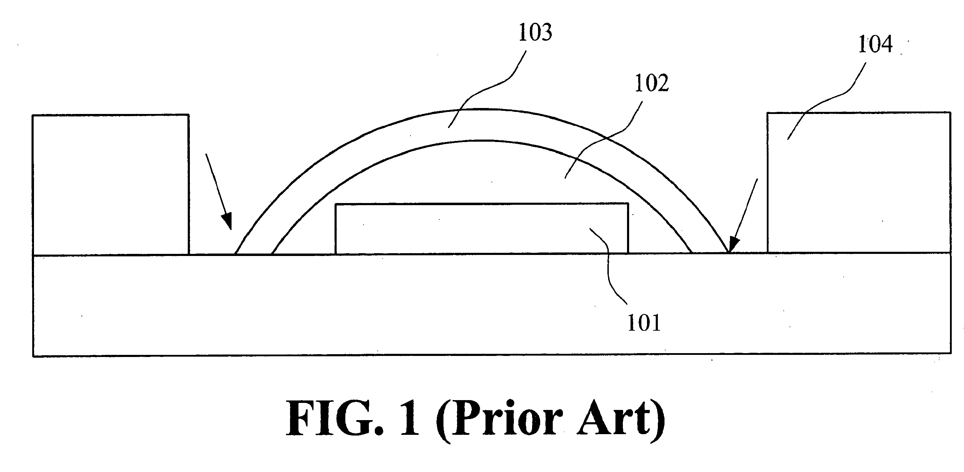

Please refer to FIG. 1, which depicts a diagram of surface finish structure in Pad Definition according to prior arts. After a bond pad layer 101 is formed on a dielectric layer, a solder mask 104 is coated. Next, after a hole is made at the position of the bond pad layer 101, a necessary step called "descum" is performed for cleaning the remaining scum. After that, the cover metal layer of nickel 102 and the cover metal layer of gold 103 are formed on the bond pad layer 101.

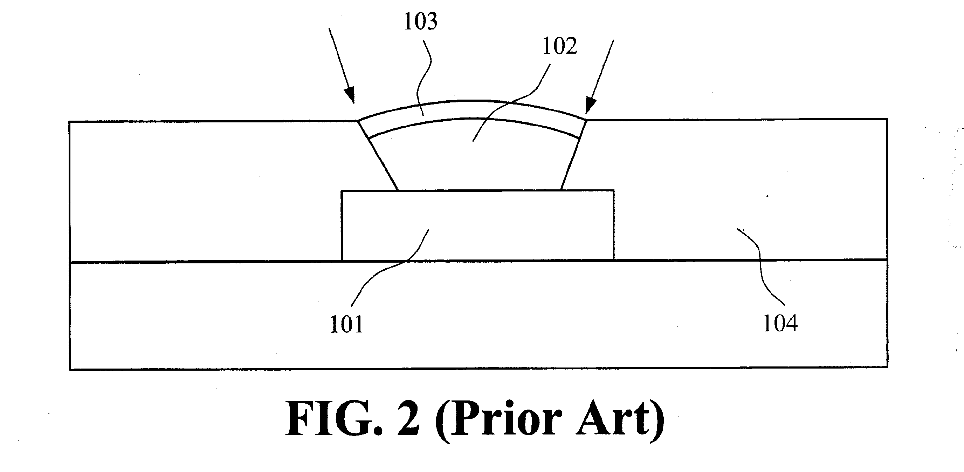

Please refer to FIG. 2, which depicts a diagram of surface finish structure in Solder Mask Definition according to prior arts. After a bond pad layer 101 is formed on a dielectric layer, a solder mask 104 is coated. Next, after a hole is made at the position of the bond pad layer 101, a necessary step called "descum" is performed for cleaning the remaining scum. After that, the cover metal layer of nickel 102 and the cover metal layer of gold 103 are formed on the bond pad layer 101. The difference between the Solder Mask Definition method and the Pad Definition method shown in FIG. 1 is that the area of the hole in the Pad Definition method is large enough to expose the whole bond pad layer 101 but solder mask 104 covers a portion of the bond pad layer 101 in the Solder Mask Definition method.

In both the Solder Mask Definition method and the Pad Definition method, the cover metal layers must be formed after first coating the solder mask 104 and making the hold. When a device is connected to the bond pad layer 101, which is generally of copper, solder may contact the copper and a wetting phenomenon may occur. The purpose of forming the cover metal layers is to prevent the contact of the bond pad layer 101 with the solder. However, delamination may occur at places of the arrow points shown in FIG. 1 or FIG. 2 due to humidity in the environment, stress between the cover metal layer and the dielectric layer or stress between the cover metal layer and the bond pad layer because they are made of different materials. Accordingly, the solder may contact with the bond pad layer 101 and then fragile IMC (Intermatallic Compound Layer) may appear to cause the contact point to be weakened and thus low down the reliability of the production made by the multi-layer substrate.

Moreover, regardless of the method is either the Solder Mask Definition method or the Pad Definition method, the bond pad layer 101 is formed on the dielectric surface, therefore, bond pad layer 101 may have chance to peel or delaminate from the dielectric layer. Accordingly, package reliability may become lowered.

Therefore, preventing contact of the bond pad layer with solder when the package is processed and enhancing the bond pad layer adhered to the dielectric layer below can raise reliability of package and the yield of the packaged production.

US 2005/0104210 A1 describes an apparatus and a method for forming a substrate having a palladium metal layer over at least one contact point of the substrate and having a flexible conductive polymer bump on the palladium plated contact point.

A nickel/gold pad structure of a semiconductor package and a fabrication method thereof are described in US 2006/0049516 A1.

US 2007/0114674 A1 discloses a solder pad interface for a solder joint on a substrate.

Furthermore, US 2004/099961 1A describes a multi-layer substrate, wherein a dielectric layer comprises polyimide.

US 2006/055021 A1 and US 2003/025202 A1 both describe wiring boards, semiconductor devices and methods of manufacturing the same.

### SUMMARY OF THE INVENTION

An objective of the present invention is to provide a surface finish structure of multi-layer substrate and manufacturing method thereof to prevent peeling or delamination of a bond pad layer by embedding the bond pad layer in a dielectric layer, therefore, to raise reliability of package of the multi-layer substrate.

Another objective of the present invention is to provide a surface finish structure of multi-layer substrate and manufacturing method thereof to form at least one cover metal layer before coating a solder mask to prevent contact of the bond pad layer with solder when the package is processed to raise reliability of package of the multi-layer substrate.

The present invention provides a method of manufacturing a surface finish structure of a multi-layer substrate. The manufacturing method comprises steps below:
coating a solder mask on a carrier surface;
forming a bond pad layer on the solder mask;
forming a dielectric layer to embed the bond pad layer into the dielectric layer;
separating the solder mask from the carrier surface;
making a hole to the solder mask at a position of the bond pad layer embedded in a surface of the dielectric layer of the multi-layer substrate; and
forming at least one cover metal layer on a surface of the bond pad layer to cover the bond pad layer.

By embedding the bond pad layer in the dielectric layer, the surface finish structure formed by the present invention can enhance adhesion intensity between the bond pad layer and the dielectric layer to prevent the peeling or the delamination of the bond pad layer from the dielectric layer, therefore, the bond pad layer can be more reliable. Because at least one cover metal layer is formed as a "barrier layer" for the bond pad layer and the solder before coating the solder mask, even occurrence of delamination due to humidity in the environment, stress between the cover metal layer and the dielectric layer or stress between the cover metal layer and the bond pad layer may exist, the present invention can still prevent contact of the bond pad layer with the solder to raise the reliability and yield to the multi-layer substrate.

### BRIEF DESCRIPTION OF THE DRAWINGS

FIG. 1 depicts a diagram of surface finish structure in Pad Definition according to prior arts.
FIG. 2 depicts a diagram of surface finish structure in Solder Mask Definition according to prior arts.
FIG. 3 depicts a diagram of surface finish structure according to a first embodiment of the present invention.
FIG. 4 depicts a diagram of surface finish structure according to a second embodiment of the present invention.
FIG. 5 depicts a diagram of surface finish structure according to a third embodiment of the present invention.
FIG. 6 depicts a diagram of surface finish structure according to a fourth embodiment of the present invention.
FIG. 7A to FIG. 7E depict a structural flow chart of a manufacturing method according to the first embodiment of the present invention.
FIG. 8A to FIG. 8E depict a structural flow chart of a manufacturing method according to the third embodiment of the present invention.

### DETAILED DESCRIPTION OF THE INVENTION

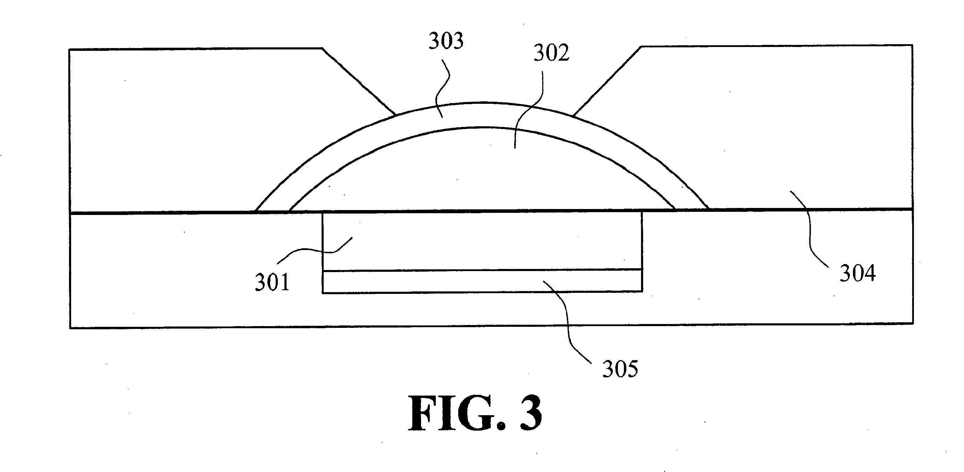

Please refer to FIG. 3, which depicts a diagram of surface finish structure according to a first embodiment of the present invention. A bond pad layer 301 of the first embodiment is embedded in a dielectric layer and the dielectric layer material can be polyimide. Moreover, at least one cover metal layer, i.e. the cover metal layer of nickel 302 and the cover metal layer of gold 303 are formed on the bond pad layer 301 and then a solder mask 304 is coated in the first embodiment. Then, a hole is made to the solder mask 304 at the position of the cover metal layer of gold 303 to expose the cover metal layer of gold 303. The solder mask 304 covers a portion of the cover metal layer of gold 303 as shown in FIG. 3.

By embedding the bond pad layer 301 in the dielectric layer, adhesion intensity between the bond pad layer 301 and the dielectric layer is enhanced to prevent delamination of the bond pad layer 301 from the dielectric layer happening to raise the reliability of the bond pad layer 301. Meanwhile, by using the Solder Mask Definition method, covering a portion of the cover metal layer of gold 303 with the solder mask 304 ensures that the delamination of the cover metal layer of nickel 302 and the cover metal layer of gold 303 due to humidity in the environment or due to stress will not happen easily. Even aforesaid delamination from the solder mask 304 or from the bond pad layer 301 does occur, the cover metal layer of nickel 302 and the cover metal layer of gold 303 still can prevent the contact of the bond pad layer with the solder. Accordingly, the reliability of the multi-layer substrate can be raised.

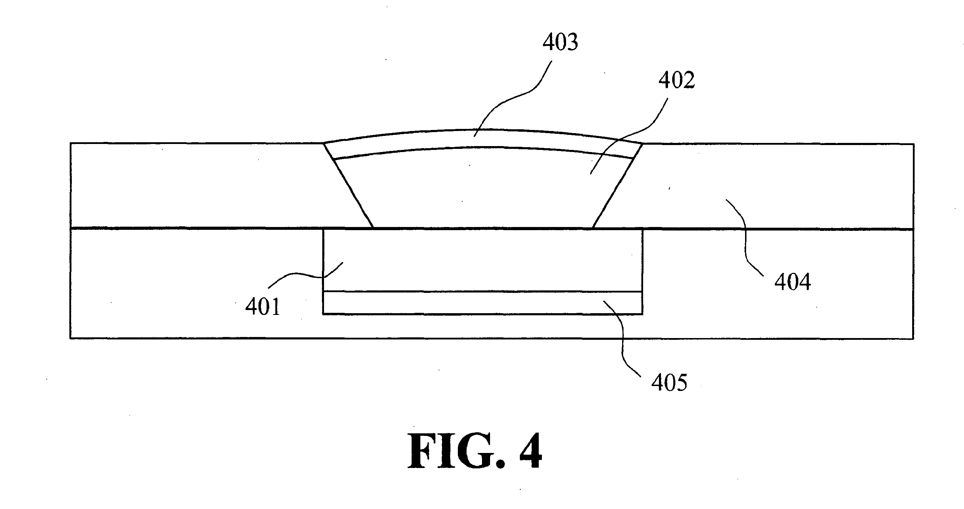

Please refer to FIG. 4, which depicts a diagram of surface finish structure according to a second embodiment of the present invention. Same as the first embodiment, a bond pad layer 401 of the second embodiment is embedded in a dielectric layer and is manufactured in a Solder Mask Definition method. After a solder mask 404 is coated, a hole is made to the solder mask 404 at the position of the bond pad layer 401 to expose thereof. The solder mask 404 covers a portion of the bond pad layer 401. Then, at least one cover metal layer, i.e. the cover metal layer of nickel 402 and the cover metal layer of gold 403 are formed on the bond pad layer 401.

The difference from the prior art shown in FIG. 2 is that the bond pad layer 401 is embedded in the dielectric layer to enhance adhesion intensity between the bond pad layer 401 and the dielectric layer. Therefore, delamination of the bond pad layer 401 from the dielectric layer will not happen easily and the reliability of the bond pad layer 401 is raised.

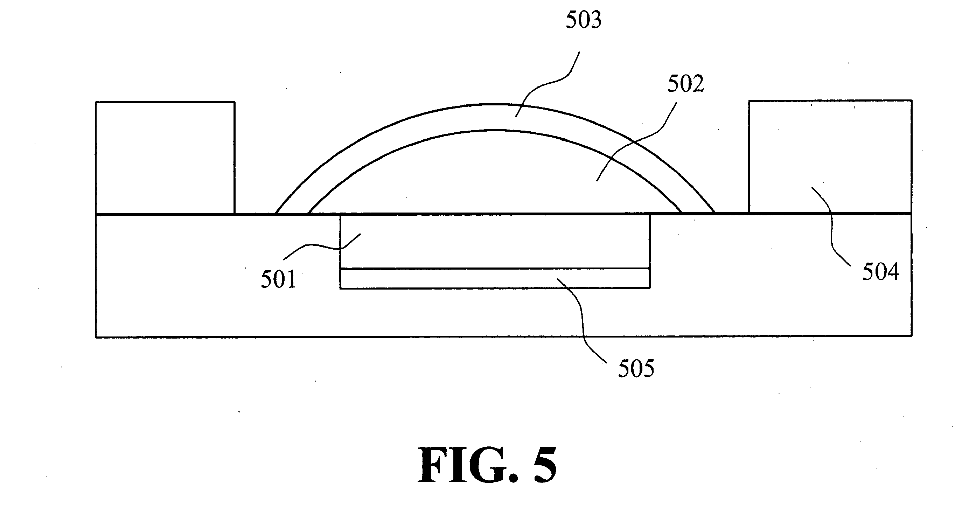

Please refer to FIG. 5, which depicts a diagram of surface finish structure according to a third embodiment of the present invention. Same as the first embodiment, a bond pad layer 501 of the second embodiment is embedded in a dielectric layer and is manufactured in a Pad Definition method. Therefore, the present invention can form at least one cover metal layer, i.e. the cover metal layer of nickel 502 and the cover metal layer of gold 503 on the bond pad layer 501 and a solder mask 504 is coated. Then, a hole is made to the solder mask 504 at the position of the cover metal layer of gold 503 to expose thereof. Moreover, the area of the hole includes the cover metal layer of gold 503 completely (more definitely includes the bond pad layer 501). Alternatively, in the third embodiment, the solder mask 504 can also be coated and the cover metal layer of nickel 502 and the cover metal layer of gold 503 can be formed after the hole is made to the solder mask 504 at the position of the bond pad layer 501.

The difference from the prior art shown in FIG. 1 is that the bond pad layer 501 is embedded in the dielectric layer to enhance adhesion intensity between the bond pad layer 501 and the dielectric layer. Therefore, delamination of the bond pad layer 501 from the dielectric layer will not happen easily and raise reliability of the bond pad layer 501.

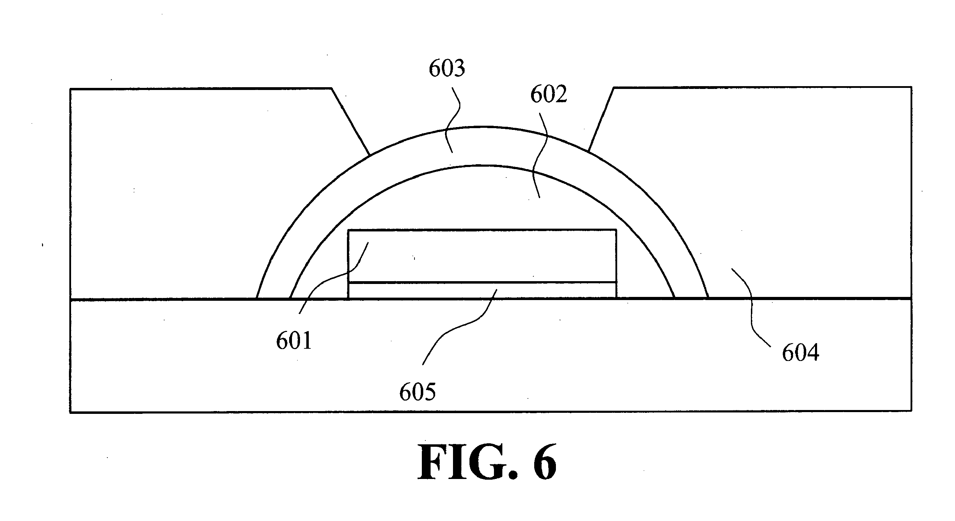

Please refer to FIG. 6, which depicts a diagram of surface finish structure according to a fourth embodiment of the present invention. A bond pad layer 601 is formed on a dielectric layer surface. In the fourth embodiment, the present invention forms at least one cover metal layer, i.e. the cover metal layer of nickel 602 and the cover metal layer of gold 603 on the bond pad layer 601. Then, the present invention coats a solder mask 604 on the cover metal layer of gold 603 and dielectric layer. After a hole is made to the solder mask 604 at the position of the cover metal layer of gold 603 to expose the cover metal layer of gold 603, the solder mask 604 covers a portion of the cover metal layer of nickel 602 and the cover metal layer of gold 603.

Because the solder mask 604 still covers a portion of aforesaid cover metal layers, even delamination of the cover metal layer of nickel 602 and the cover metal layer of gold 603 from the solder mask 304 or from the bond pad layer 301 occurs, they still can prevent the contact of the bond pad layer with the solder. Accordingly, the reliability of the bond pad layer 601 and the multi-layer substrate can be raised.

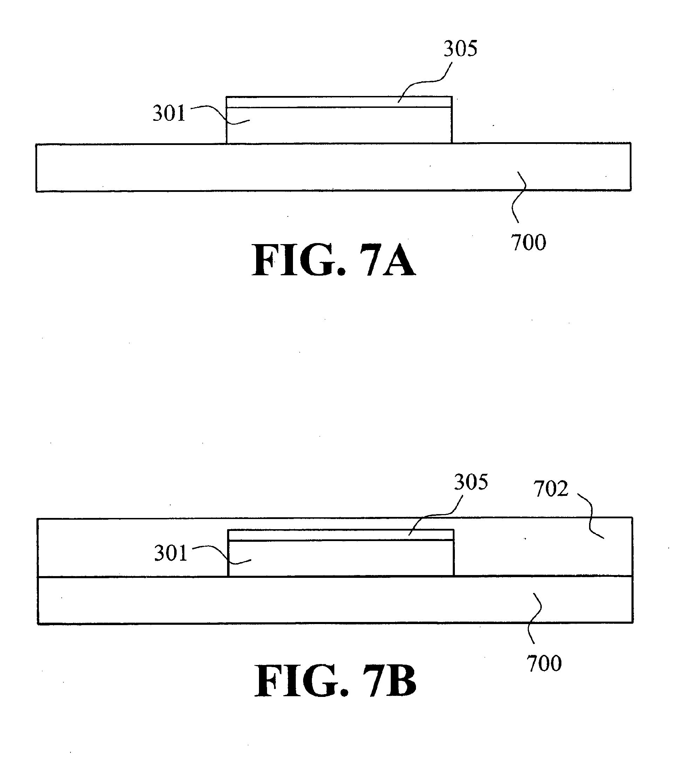

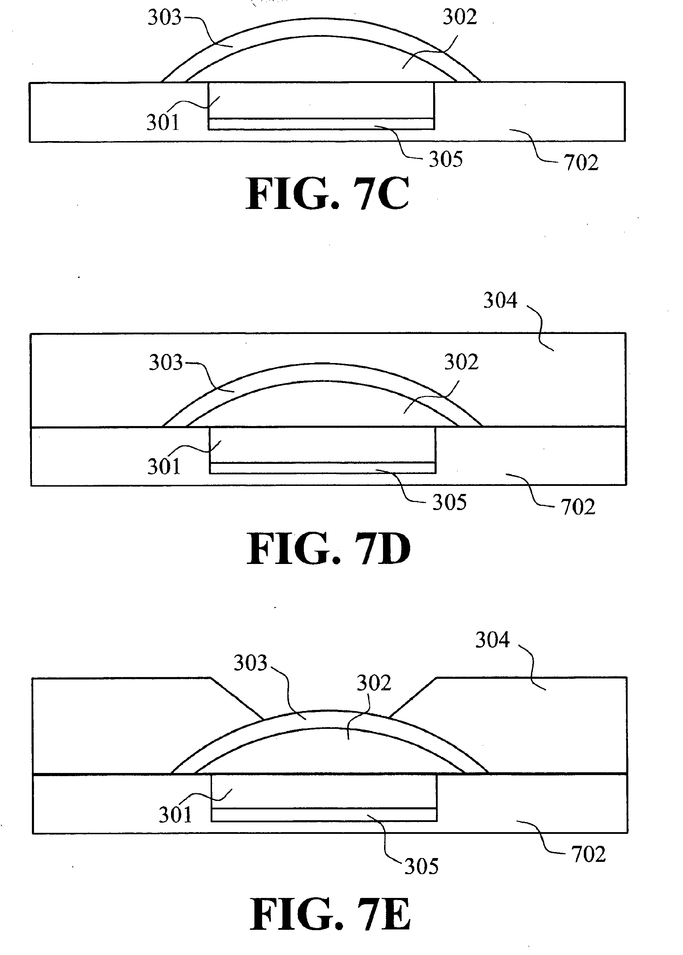

Please refer to FIG. 7A to FIG. 7E, which depict a structural flow chart of a manufacturing method according to the first embodiment of the present invention. FIG. 7A shows steps of forming a bond pad layer 301 on a surface of a carrier 700 and implementing an interface adhesion enhancing process 305, such as, an oxygen or argon plasma process. FIG. 7B shows a step of forming a dielectric layer 702 to cover the carrier 700 completely. FIG. 7C shows steps of separating the bond pad layer 301 and the dielectric layer 702 from the carrier surface. After turning to upside down, the cover metal layer of nickel 302 and the cover metal layer of gold 303 are formed on the bond pad layer 301 to cover thereof. FIG. 7D shows a step of coating a solder mask 304 to cover the cover metal layer of nickel 302 and the cover metal layer of gold 303 completely.

FIG. 7E shows a step of making a hole to the solder mask 304 at a position of the cover metal layer of gold 303 to be exposed thereof. The solder mask 304 covers a portion of the cover metal layer of gold 303 to realize a surface finish structure of embedding the bond pad layer 301 in the dielectric layer 702 and covering a portion of the cover metal layer of gold 303 with the solder mask 304. Mentioned prior regarding the third embodiment as shown in FIG. 5, the present invention can also form the bond pad layer 501 in the same way by controlling the area of the hole to include the bond pad layer 301 during the step of making the hole shown in FIG. 7E. If the bond pad layer 401 of the second embodiment shown in FIG 4 is desired, the present invention can switch the step shown in FIG. 7C and the step shown in FIG. 7D, i.e. forming the solder mask 304 and making the hole to cover a portion of the bond pad layer 301 with the solder mask 304 and then the cover metal layer of nickel 302 and the cover metal layer of gold 303 are formed.

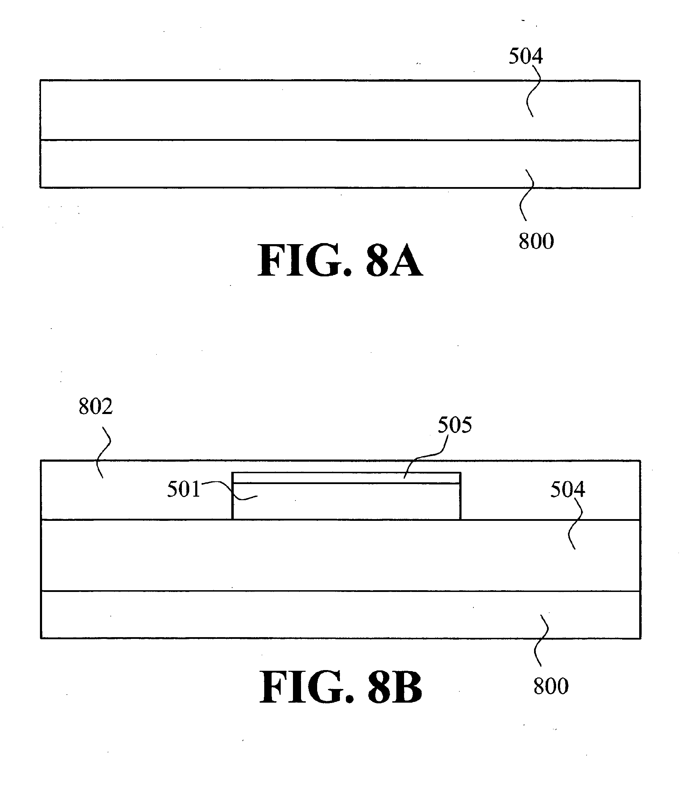

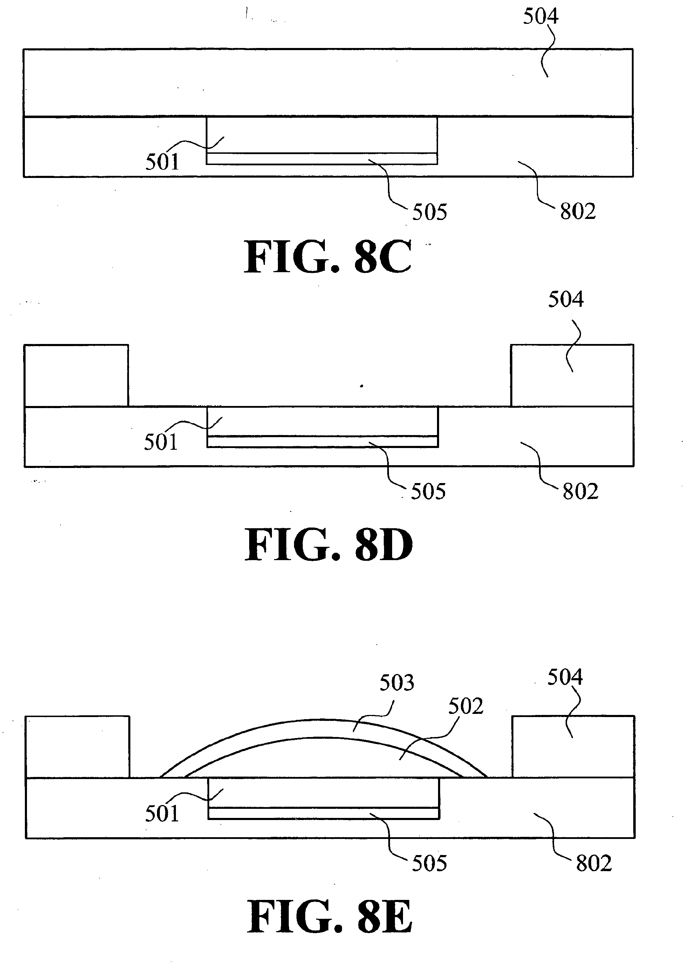

Please refer to FIG. 8A to FIG. 8E, which depict a structural flow chart of a manufacturing method according to the third embodiment of the present invention. FIG. 8A shows a step of forming a solder mask 504 on a surface of a carrier 800. FIG. 8B shows steps of forming a bond pad layer 501 on the solder mask 504 and forming a dielectric layer 802 thereon. Similarly, an interface adhesion enhancing process 505 can be implemented between the bond pad layer 501 and the dielectric layer 802, such as, an oxygen or argon plasma process. FIG. 8C shows steps of separating the solder mask 504 from the carrier 800 surface and turning the dielectric layer 802 upside down.

FIG. 8D shows a step of making a hole to the solder mask 504 at the position of the bond pad layer 501 which is embedded in the dielectric layer 802 to expose the bond pad layer 501. Furthermore, the area of the hole includes the whole area of the bond pad layer 501 completely. FIG. 8E shows a step of forming a cover metal layer of nickel 502 and a cover metal layer of gold 503 on the bond pad layer 501 to cover it thereon. Accordingly, a surface finish structure of embedding the bond pad layer 501 in the dielectric layer 802 can be realized. Mentioning about the second embodiment shown in FIG. 4, the present invention can also form the bond pad layer 401 in the same way by covering a portion of the bond pad layer 501 with the solder mask 504 during the step of making the hole shown in FIG. 8D.

Furthermore, in all embodiments of the present invention, interface adhesion enhancing processes marked with 305, 405, 505 and 605 in respective figures can be implemented between the bond pad layers 301, 401, 501 and 601 and the dielectric layers to increase adhesion intensity therebetween. Then, peeling or delamination of the bond pad layers 301, 401, 501 and 601 can be prevented better.

In conclusion, the present invention employs a carrier to manufacture the bond pad layer embedded in the dielectric layer to increase the adhesive fore of the bond pad layer to the dielectric layer for preventing peeling or delamination of the bond pad layer and raising the reliability thereof. Meanwhile, the cover metal layers are formed before the solder mask and cover a portion of the cover metal layers with the solder mask to ensure that the delamination of the cover metal layers due to humidity in the environment or stress will not happen. The cover metal layers still can prevent the contact of the bond pad layer with the solder, even delamination of the cover metal layers from the solder mask or from the bond pad layer occurs, therefore, the reliability of the bond pad layer can guaranteed and the reliability of the multi-layer substrate and the yield of the productions made thereby can also be raised, accordingly.

As is understood by a person skilled in the art, the foregoing preferred embodiments of the present invention are illustrative rather than limiting of the present invention. It is intended that they cover various modifications and similar arrangements be included within the scope of the appended claims, the scope of which should be accorded the broadest interpretation so as to encompass all such modifications and similar structure.

## Claims

1. A method of manufacturing a surface finish structure of a multi-layer substrate, comprising steps of:
coating a solder mask (504) on a carrier (800) surface;
forming a bond pad layer (501) on the solder mask;
forming a dielectric layer (802) to embed the bond pad layer into the dielectric layer;
separating the solder mask from the carrier surface;
making a hole to the solder mask at a position of the bond pad layer embedded in a surface of the dielectric layer of the multi-layer substrate; and
forming at least one cover metal layer (502, 503) on a surface of the bond pad layer to cover the bond pad layer.

2. The manufacturing method of claim 1, **characterized in that** the solder mask (404) covers a portion of the bond pad layer (401).

3. The manufacturing method of claim 1, **characterized in that** an area of the hole comprises a whole area of the bond pad layer (501).

## Patentansprüche

1. Verfahren zur Herstellung einer Oberflächenstruktur eines mehrschichtigen Substrats, wobei das Verfahren folgende Schritte umfasst:
- Beschichten einer Lötmaske (504) auf der Oberfläche eines Trägers (800);
- Ausbilden einer Kontaktinselschicht (501) auf der Lötmaske;
- Ausbilden einer dielektrischen Schicht (802), um die Kontaktinselschicht in die dielektrische Schicht einzubetten;
- Trennen der Lötmaske von der Trägeroberfläche;
- Herstellen eines Loches in der Lötmaske an einer Position der Kontaktinselschicht, die in eine Oberfläche der dielektrischen Schicht des mehrschichtigen Substrats eingebettet ist; und
- Ausbilden mindestens einer Metallüberzugsschicht (502, 503) auf einer Oberfläche der Kontaktinselschicht, um die Kontaktinselschicht zu bedecken.

2. Herstellungsverfahren nach Anspruch 1, **dadurch gekennzeichnet, dass** die Lötmaske (404) einen Abschnitt der Kontaktinselschicht (401) bedeckt.

3. Herstellungsverfahren nach Anspruch 1, **dadurch gekennzeichnet, dass** ein Bereich des Loches einen gesamten Bereich der Kontaktinselschicht (501) umfasst.

## Revendications

1. Procédé de fabrication d'une structure de fini de surface d'un substrat multicouche, comprenant les étapes suivantes :
- application d'un masque de soudure (504) sur une surface de support (800) ;
- formation d'une couche de plot de connexion (501) sur le masque de soudure ;
- formation d'une couche diélectrique (802) pour incorporer la couche de plot de connexion dans la couche de diélectrique ;
- séparation du masque de soudure de la surface de support ;
- réalisation d'un trou dans le masque de soudure au niveau d'une position de la couche de plot de connexion incorporée dans une surface de la couche diélectrique du substrat multicouche ; et
- formation d'au moins une couche métallique de recouvrement (502, 503) sur une surface de la couche de plot de connexion pour recouvrir la couche de plot de connexion.

2. Procédé de fabrication selon la revendication 1, **caractérisé en ce que** le masque de soudure (404) recouvre une partie de la couche de plot de connexion (401).

3. Procédé de fabrication selon la revendication 1, **caractérisé en ce qu'**une zone du trou comprend une zone entière de la couche de plot de connexion (501).
